# EUROPÄISCHE PATENTSCHRIFT

(11) **EP 3 887 194 B1**
(45) Veröffentlichungstag und Bekanntmachung des Hinweises auf die Patenterteilung: **09.09.2026**
(21) Anmeldenummer: 19809054.0
(22) Anmeldetag: 22.11.2019
(51) Int. Cl.: B60L 3/00, B60L 3/04, G01R 31/00

(54) **ÜBERWACHUNGSSCHALTUNG FÜR EIN INTERLOCKSYSTEM, INTERLOCKSYSTEM, ANORDNUNG MIT EINEM INTERLOCKSYSTEM UND EINER FUNKTIONSEINHEIT SOWIE VERFAHREN ZUM BETREIBEN EINES INTERLOCKSYSTEMS**
MONITORING CIRCUIT FOR AN INTERLOCK SYSTEM, INTERLOCK SYSTEM, ASSEMBLY HAVING AN INTERLOCK SYSTEM AND HAVING A FUNCTIONAL UNIT, AND METHOD FOR OPERATING AN INTERLOCK SYSTEM
CIRCUIT DE SURVEILLANCE POUR UN SYSTÈME DE VERROUILLAGE, SYSTÈME DE VERROUILLAGE, ARRANGEMENT AVEC UN SYSTÈME DE VERROUILLAGE ET UNE UNITÉ FONCTIONNELLE AINSI QUE PROCÉDÉ DE FONCTIONNEMENT D'UN SYSTÈME DE VERROUILLAGE

(30) Priorität: 30.11.2018 DE 102018130575
(43) Veröffentlichungstag der Anmeldung: 06.10.2021
(73) Patentinhaber: Valeo Electrification, 95892 Cergy Pontoise (FR)
(72) Erfinder: EDELHÄUSER, Rainer, 90411 Nürnberg (DE)
(74) Vertreter: Valeo Powertrain Systems
(86) Internationale Anmeldenummer: PCT/EP2019/082266
(87) Internationale Veröffentlichungsnummer: WO 2020/109169

(56) Entgegenhaltungen:
- WO-A1-2018/030749
- CN-A- 105 313 700
- DE-A1- 102009 012 078
- DE-A1- 102010 045 990
- DE-A1- 102010 045 990
- DE-A1- 102013 219 141
- DE-A1- 102013 219 141
- DE-C1- 10 210 665
- US-A1- 2017 292 982

## Beschreibung

Die vorliegende Erfindung betrifft eine Überwachungsschaltung für ein Interlocksystem, das eine erste Überwachungsleitung, eine zweite Überwachungsleitung und wenigstens eine Leitungsbrücke, mittels welcher die Überwachungsleitungen in einem geschlossenen Zustand des Interlocksystems elektrisch leitend verbunden sind, aufweist, umfassend eine Signalerzeugungseinrichtung, welche zum Erzeugen eines zwischen einer ersten Überwachungsspannung und einer zweiten Überwachungsspannung wechselnden, auf ein Bezugspotential bezogenen Überwachungssignals für die erste Überwachungsleitung eingerichtet ist, und eine Signalauswertungseinrichtung, mittels welcher ein auf das Bezugspotential bezogener Spannungsverlauf auf der zweiten Überwachungsleitung erfassbar ist.

Daneben betrifft die Erfindung ein Interlocksystem, eine Anordnung mit einem Interlocksystem und einer Funktionseinheit und ein Verfahren zum Betreiben eines Interlocksystems.

Interlocksysteme dienen der Erkennung einer Störung von elektrischen Netzen, beispielsweise eines Hochspannungsnetzes eines Fahrzeugs. Eine solche Störung kann ein unerwünschtes Lösen einer Steckverbindung oder ein unzulässiger manueller Eingriff, beispielsweise ein unzulässiges Öffnen einer Schutzabdeckung, sein, in dessen Folge spannungsführende Teile freiliegen können. Typischerweise wird das elektrische Netz bei Erkennung eines solchen Fehlers spannungsfrei geschaltet. Das Interlocksystem weist dazu durch wenigstens eine Leitungsbrücke verbundene Überwachungsleitungen auf, wobei eine Überwachungsschaltung vorgesehen ist, welche die Entfernung einer Leitungsbrücke, die beispielsweise dem zuvor genannten Steckverbinder zugeordnet ist, erkennt.

Das Dokument DE 10 2010 045 990 A1 offenbart ein Verfahren zum Betreiben eines Kraftwagens mit einer Hochspannungsquelle zum Versorgen von Komponenten eines Hochspannungsbordnetzes mit elektrischer Energie, bei welchem eine Signalschleife, welche die Komponenten verbindet, mit einem pulsweitenmodulierten Signal beaufschlagt wird, wobei das Vorliegen des Signals durch wenigstens eine Messvorrichtung detektiert wird und, falls das Signal nicht vorliegt, die Hochspannungsquelle durch wenigstens ein elektrisches Trennmittel vom Hochspannungsbordnetz abgetrennt wird.

Durch die Verwendung von zwei durch das pulsweitenmodulierte Signal realisierten Überwachungsspannungen können zwar durch Induktion in die Überwachungsleitungen eingestreute Störsignale vom pulsweitenmodulierten Signal unterschieden werden. Eine genauere Bestimmung der Störung ist jedoch nur sehr unzureichend möglich. US 2017/292982 A1; ebenfalls DE 102 10 665 C1 offenbaren jeweils Überwachungsschaltung für ein Interlocksystem, das eine erste Überwachungsleitung, eine zweite Überwachungsleitung und wenigstens eine Leitungsbrücke, mittels welcher die Überwachungsleitungen in einem geschlossenen Zustand des Interlocksystems elektrisch leitend verbunden sind, aufweist, umfassend eine Signalerzeugungseinrichtung gemäß dem Stand der Technik.

Der Erfindung liegt mithin die Aufgabe zugrunde, eine verbesserte Möglichkeit zum Betrieb eines Interlocksystems für ein Fahrzeug anzugeben.

Zur Lösung dieser Aufgabe wird erfindungsgemäß bei einer Überwachungsschaltung der eingangs genannten Art vorgeschlagen, dass die Signalauswertungseinrichtung zum Ermitteln einer durch eine auf das Bezugspotential bezogene Störspannung verursachten Störung auf einer der Überwachungsleitungen und/oder einer Störung der Überwachungsschaltung mittels eines Vergleichs des Spannungsverlaufs mit einem vorgegeben ersten Toleranzintervall um die erste Überwachungsspannung und mit einem vorgegebenen zweiten Toleranzintervall um die zweite Überwachungsspannung eingerichtet ist.

Die Erfindung beruht auf der Überlegung, zwei Toleranzintervalle zu definieren, in denen der Spannungsverlauf auf der zweiten Überwachungsleitung wechselweise in einem störungsfreien Betrieb liegt, so dass Störungen, wie Kurzschlüsse zur Störspannung, anhand eines Unterschieds zwischen dem erfassten Spannungsverlaufs und dem Spannungsverlauf im störungsfreien Betrieb genauer ermittelt werden können. Alternativ oder zusätzlich können auch Störungen der Überwachungsschaltung selbst, beispielsweise sogenannte "stuck at"-Fehler, durch den Vergleich anhand der Toleranzintervalle ermittelt werden.

Typischerweise ist die Signalauswertungseinrichtung dazu eingerichtet, bei einer erkannten Störung ein Auslösesignal auszugeben, durch welches eine Trenneinrichtung ansteuerbar ist, um eine Spannungsquelle von einer Funktionseinheit, der die Leitungsbrücke zugeordnet ist, zu trennen. Typischerweise weist das Überwachungssignal ein Tastverhältnis von 50% auf. Es kann jedoch auch ein davon abweichendes Tastverhältnis vorgesehen sein. Die Signalauswertungseinrichtung kann ferner dazu eingerichtet sein, eine Störungsinformation auszugeben, welche die ermittelte Störung näher beschreibt. Dies erleichtert eine Fehlerdiagnose nach dem Ermitteln der Störung. Typischerweise bilden die Überwachungsspannungen keine Begrenzung ihres jeweiligen Toleranzintervalls. Die Toleranzintervalle sind vorteilhafterweise so gewählt, dass betriebsübliche, insbesondere nicht auf eine Störung hinweisende, Schwankungen des Spannungsverlaufs, innerhalb des oder eines jeweiligen Toleranzintervalls liegen.

Als Störspannung können insbesondere Potentialunterschiede zum Bezugspotential in Betracht, die einen niedrigen Innenwiderstand aufweisen und insofern als "harte" Spannung erachtet werden können. Mit anderen Worten kommen als Störspannung solche Spannungen in Betracht, die einen so niedrigen Innenwiderstand aufweisen, dass der Spannungsverlauf den Wert der Störspannung annimmt, wenn ein Kurzschluss zu dieser Spannung vorliegt. Die Überwachungsspannungen sind zweckmäßigerweise derart gewählt, dass der durch sie erzeugte Spannungsverlauf für die Signalauswertungseinrichtung wohlunterscheidbar von der Störspannung ist.

Die Toleranzintervalle sind zweckmäßigerweise überlappungsfrei definiert. D. h., zwischen den Toleranzintervallen liegt ein Potentialintervall, in dem der Spannungsverlauf bei einem störungsfreien Betrieb des Interlocksystems nicht längere Zeit liegt. Alternativ oder zusätzlich umfassen die Toleranzintervalle zur Erkennung der Störspannung vorgesehene Spannungswerte nicht.

Anhand der Toleranzintervalle lassen sich beispielsweise folgende Störungen ermitteln:
Die Signalauswertungseinrichtung kann zum Ermitteln der Störung auf den Überwachungsleitungen anhand eines nicht zwischen den Toleranzintervallen liegenden erfassten Wertes des Spannungsverlaufs, der außerhalb der Toleranzintervalle liegt, eingerichtet sein. Daraus kann auf eine Störung in Form eines Kurzschlusses mit einem innerhalb oder außerhalb des Interlocksystems vorliegenden Potential, dessen Potentialunterschied zum Bezugspotential die Störspannung bildet, geschlossen werden. Die Signalauswertungseinrichtung kann dabei dazu eingerichtet sein, eine einen Kurzschluss beschreibende Störinformation auszugeben.

Die Signalauswertungseinrichtung kann ferner zum Ermitteln der Störung auf den Überwachungsleitungen anhand von wenigstens zwei aufeinanderfolgend erfassten, zwischen den Toleranzintervallen liegenden Werten des Spannungsverlaufs eingerichtet sein. Auch daraus kann auf einen Kurzschluss mit dem zuvor beschriebenen innerhalb oder außerhalb des Interlocksystems vorliegenden Potentials geschlossen werden. Hierbei werden jedoch zweckmäßigerweise wenigstens zwei aufeinanderfolgend erfasste Werte des Spannungsverlaufs ausgewertet. Denn die Erfassung lediglich eines zwischen den Toleranzintervallen liegenden Werts des Spannungsverlaufs kann dadurch verursacht sein kann, dass der Wert während eines Wechsels zwischen den Überwachungsspannungen erfasst wurde und der Spannungsverlauf nur eine endliche Flankensteilheit aufweist. Wenn jedoch wenigstens zwei aufeinanderfolgende, zwischen den Toleranzintervallen liegende Werte des Spannungsverlaufs erfasst werden, kann, bei Annahme eines ausreichend großen Verhältnisses der Flankensteilheit zu einem Abtastintervall, davon ausgegangen werden, dass die Störspannung dauerhaft an einer der Überwachungsleitungen liegt. Die Signalauswertungseinrichtung kann dabei dazu eingerichtet sein, die oder eine einen Kurzschluss beschreibende Störinformation auszugeben.

Die Signalauswertungseinrichtung kann ferner zum Ermitteln der Störung der Überwachungsschaltung anhand von mehreren aufeinanderfolgend erfassten Werten des Spannungsverlaufs, die für oder länger als eine vorgegebene Dauer innerhalb eines Toleranzintervalls liegen, eingerichtet sein. Es kann mithin auf einen "stuck at"-Fehler geschlossen werden, wenn die aufeinanderfolgend erfassten Werte des Spannungsverlaufs eines der Toleranzintervalle nicht mehr verlassen. Die vorgegebene Dauer ist bevorzugt in Abhängigkeit der vorgesehenen Dauer der Erzeugung einer jeweiligen Überwachungsspannung durch die Signalerzeugungseinrichtung gewählt. Die Signalauswertungseinrichtung kann dabei dazu eingerichtet sein, eine Störungsinformation auszugeben, die eine Störung der Überwachungsschaltung beschreibt.

Gemäß einer Ausgestaltungsvariante der Signalauswertungseinrichtung umfasst diese zum Vergleichen des Spannungsverlaufs mehrere Komparatoren, deren Referenzwerte Grenzen der Toleranzintervalle entsprechen. Gemäß einer alternativen Ausgestaltungsvariante umfasst die Signalauswertungseinrichtung zum Vergleichen des Spannungsverlaufs einen Analog-Digital-Wandler zum Wandeln des Spannungsverlaufs in Binärdaten. Die Signalauswertungseinrichtung kann eine Auswerteeinheit aufweisen, welche Ausgangssignale der Komparatoren oder die Binärdaten erhält.

Bei der erfindungsgemäßen Überwachungsschaltung kann vorgesehen sein, dass eine einen Signalzustand des Überwachungssignals beschreibende Signalinformation von der Signalerzeugungseinrichtung an die Signalauswertungseinrichtung übermittelbar ist und die Signalauswertungseinrichtung zum Erkennen der Störung anhand eines Vergleichs eines erfassten Werts des Spannungsverlaufs mit dem erhaltenen Signalzustand des Überwachungssignals eingerichtet ist. Beim Ermitteln der Störung kann so, bei Annahme hinreichend kleiner Signallaufzeiten der Signalinformation, ein Vergleich eines Soll-Spannungsverlaufs, der durch die Signalinformation beschrieben wird, mit dem durch die erfassten Werte beschriebenen (Ist-)Spannungsverlaufs erfolgen. Dadurch kann die Überwachungsschaltung vorteilhafterweise auch mit einer unregelmäßigen Folge von ersten Versorgungspotentialen und zweiten Versorgungspotentialen betrieben werden.

Bei der erfindungsgemäßen Überwachungsschaltung kann vorgesehen sein, dass die Signalerzeugungseinrichtung dazu eingerichtet ist, das Überwachungssignal aus einer auf das Bezugspotential bezogenen Versorgungsspannung mit einem ersten Versorgungspotential und einem zweiten Versorgungspotential zu erzeugen.

Die Versorgungsspannung stellt insoweit auch eine harte Spannung dar. Die Überwachungsspannungen sind zweckmäßigerweise derart gewählt, dass der durch sie erzeugte Spannungsverlauf für die Signalauswertungseinrichtung wohlunterscheidbar von den Versorgungspotentialen ist. Zweckmäßigerweise ist das zweite Versorgungspotential das Bezugspotential. Das erste Versorgungspotential ist typischerweise höher als das zweite Potential.

Besonders vorteilhaft ist es, wenn die Signalerzeugungseinrichtung dazu eingerichtet ist, das Überwachungssignal derart aus der Versorgungsspannung zu erzeugen, dass die Überwachungsspannungen zwischen den Versorgungspotentialen liegen. Typischerweise liegt die zweite Überwachungsspannung zwischen der ersten Überwachungsspannung und dem zweiten Versorgungspotential.

Die Signalauswertungseinrichtung kann zum Ermitteln der Störung auf den Überwachungsleitungen anhand eines nicht zwischen den Toleranzintervallen liegenden erfassten Werts des Spannungsverlaufs, der seitens des ersten Versorgungspotentials außerhalb des ersten Toleranzintervalls liegt, eingerichtet sein. Daraus kann auf eine Störung in Form eines Kurzschlusses einer der Überwachungsleitungen mit dem ersten Versorgungspotential als Störspannung geschlossen werden. Die Signalauswertungseinrichtung kann dabei dazu eingerichtet sein, eine einen Kurzschluss zur ersten Versorgungspotential beschreibende Störinformation auszugeben.

Alternativ oder zusätzlich kann die Signalauswertungseinrichtung zum Ermitteln der Störung auf den Überwachungsleitungen anhand eines nicht zwischen den Toleranzintervallen liegenden erfassten Werts des Spannungsverlaufs, der seitens des zweiten Versorgungspotentials außerhalb des zweiten Toleranzintervalls liegt, eingerichtet sein. In diesem Fall kann auf eine Störung durch das zweite Versorgungspotential als Störspannung geschlossen werden. Die Signalauswertungseinrichtung kann dazu eingerichtet sein, eine Störungsinformation, welche einen Kurzschluss zum zweiten Versorgungspotential oder eine Unterbrechung der Verbindung der Überwachungsleitungen durch die Leitungsbrücke beschreibt, auszugeben. Typischerweise wird nämlich die Unterbrechung der Überwachungsleitungen dadurch erkannt, dass der Spannungsverlauf auf dem zweiten Versorgungspotential liegt. Ein Kurzschluss zum zweiten Versorgungspotential lässt sich insofern typischerweise nicht von einer Unterbrechung der Überwachungsleitungen durch eine Entfernung der Leitungsbrücke unterscheiden.

Bevorzugt umfasst die Signalerzeugungseinrichtung der erfindungsgemäßen Überwachungsschaltung eine Generatoreinheit, welche zum Ausgeben eines die Wechsel zwischen den Überwachungsspannungen beschreibenden Generatorsignals eingerichtet ist, und eine Spannungswandlungseinheit, welche zum Wandeln der Versorgungsspannung in Abhängigkeit des Generatorsignals eingerichtet ist. Dabei lässt sich eine besonders kompakte, preisgünstige und aufwandsarme Realisierung der Überwachungsschaltung erzielen, wenn die Generatoreinheit und/oder der Analog-Digital-Wandler und/oder eine Auswerteeinheit der Signalauswertungseinrichtung durch einen gemeinsamen Mikrocontroller realisiert sind.

Die Spannungswandlungseinheit kann einen zwischen die Versorgungspotentiale geschalteten Spannungsteiler und einen durch das Generatorsignal ansteuerbares Schaltelement umfassen, durch das ein Widerstandswert eines Zweigs des Spannungsteilers veränderbar ist. Dies erlaubt eine aufwandsarme schaltungstechnische Realisierung der Signalerzeugungseinrichtung. Bevorzugt sind das Schaltelement und ein Widerstandselement in Reihe geschaltet und ihrerseits parallel zu einem Widerstandselement des Zweigs, dessen Widerstandswert dadurch veränderbar ist, geschaltet.

Daneben kann die Signalerzeugungseinrichtung einen Impedanzwandler umfassen, welcher zum Wandeln eines Ausgangssignals der Spannungswandlungseinheit in das Überwachungssignal eingerichtet ist. Der Impedanzwandler ermöglicht es, einen hochohmigen Spannungswandler in der Spannungswandlungseinheit einzusetzen, da der Impedanzwandler den erforderlichen Strom auf den Überwachungsleitungen treibt.

Bei der erfindungsgemäßen Überwachungsschaltung ist ferner zweckmäßigerweise vorgesehen, dass die Signalauswertungseinrichtung einen Spannungsteiler umfasst, an dessen Abgriff ein den Spannungsverlauf repräsentierendes Spannungsverlaufssignal erfassbar ist. Insbesondere im Hinblick auf den Einsatz des Impedanzwandlers kann der Spannungsteiler der Signalauswertungseinrichtung niederohmig im Vergleich zu den Widerstandswerten des Spannungsteilers der Signalerzeugungseinrichtung sein. Durch den Spannungsteiler kann das Spannungsverlaufssignal auch an einen Erfassungsbereich des Analog-Digital-Wandlers angepasst werden.

Die Signalauswertungseinrichtung kann auch ein Widerstandselement, das zwischen einen Eingang für die zweite Überwachungsleitung und das zweite Versorgungspotential geschaltet und im Vergleich zur Summe der Widerstandswerte des Spannungsteilers niederohmig ist, aufweisen. Dadurch kann ein Potential an der Signalauswertungseinrichtung definiert und schnell auf einen vorgegebenen Wert außerhalb der Toleranzintervalle gebracht werden, falls die erste Überwachungsleitung und die zweite Überwachungsleitung unterbrochen sind. Alternativ kann die Signalauswertungseinrichtung eine Stromsenke aufweisen, welche es ermöglicht, den Strom auf den Überwachungsleitungen aufrechtzuerhalten.

Daneben betrifft die Erfindung ein Interlocksystem für ein Fahrzeug, umfassend eine erste Überwachungsleitung, eine zweite Überwachungsleitung und wenigstens eine Leitungsbrücke, mittels welcher die Überwachungsleitungen in einem geschlossenen Zustand des Interlocksystems elektrisch leitend verbunden sind, sowie eine erfindungsgemäße Überwachungsschaltung, wobei die Signalerzeugungseinrichtung mit der ersten Überwachungsleitung und die Signalauswertungseinrichtung mit der zweiten Überwachungsleitung verbunden sind.

Insbesondere weist das Interlocksystem wenigstens eine weitere Leitungsbrücke auf. Die Leitungsbrücken können in Reihe zwischen der ersten und zweiten Überwachungsleitung verschaltet sein. Alternativ kann die Überwachungsschaltung für jede weitere Leitungsbrücke eine weitere entsprechende Signalauswertungseinheit aufweisen.

Die Erfindung betrifft ferner eine Anordnung mit einem erfindungsgemäßen Interlocksystem und mit einer Funktionseinheit, welche mittels der Leitungsbrücke oder den Leitungsbrücken überwachbar ist und dazu eingerichtet ist, während ihres Betriebs eine auf das Bezugspotential bezogene Spannung als Störspannung bereitzustellen, wobei die Spannung außerhalb der Toleranzintervalle liegt. Die Funktionseinheit kann beispielsweise ein Wechselrichter für ein Fahrzeugzeug sein. Die oder eine Leitungsbrücke sind insbesondere derart angeordnet, dass sie die Überwachungsleitungen beim Öffnen einer spannungsführende Teile der Funktionseinheit abdeckenden Abdeckung oder beim Lösen eines Steckverbinders trennen.

Die Anordnung kann auch eine Trenneinrichtung umfassen, die durch ein bei einer ermittelten Störung ausgegebenes Auslösesignal zum Trennen einer Hochvoltbatterie von der Funktionseinheit ansteuerbar ist.

Außerdem betrifft die Erfindung ein Verfahren zum Betreiben eines Interlocksystems, das eine erste Überwachungsleitung, eine zweite Überwachungsleitung und wenigstens eine Leitungsbrücke, mittels welcher die Überwachungsleitungen in einem geschlossenen Zustand des Interlocksystems elektrisch leitend verbunden sind, aufweist, umfassend folgende Schritte:
- Erzeugen eines zwischen einer ersten Überwachungsspannung und einer zweiten Überwachungsspannung wechselnden, auf ein Bezugspotential bezogenen Überwachungssignals für die erste Überwachungsleitung,
- Erfassen eines auf das Bezugspotential bezogenen Spannungsverlaufs auf der zweiten Überwachungsleitung,
- Ermitteln einer durch eine auf das Bezugspotential bezogene Störspannung verursachten Störung auf einer der Überwachungsleitungen und/oder einer Störung der Überwachungsschaltung mittels eines Vergleichs des Spannungsverlaufs mit einem vorgegeben ersten Toleranzintervall um die erste Überwachungsspannung und mit einem vorgegebenen zweiten Toleranzintervall um die zweite Überwachungsspannung.

Sämtliche Ausführungen zur erfindungsgemäßen Überwachungsschaltung lassen sich analog auf das erfindungsgemäße Interlocksystem, die erfindungsgemäße Anordnung und das erfindungsgemäße Verfahren übertragen, so dass auch mit diesen die zuvor genannten Vorteile erzielt werden können.

Weitere Vorteile und Einzelheiten der vorliegenden Erfindung ergeben sich aus den im folgenden beschriebenen Ausführungsbeispielen sowie anhand der Zeichnungen. Diese sind schematische Darstellungen und zeigen:
- Fig. 1: ein Schaltbild eines Ausführungsbeispiels der erfindungsgemäßen Anordnung mit einem Ausführungsbeispiel des erfindungsgemäßen Interlocksystems, das einen Ausführungsbeispiel der erfindungsgemäßen Überwachungsschaltung umfasst;
- Fig. 2: zeitliche Spannungsverläufe während eines Betriebs des in Fig. 1 gezeigten Interlocksystems;
- Fig. 3 und 3a: jeweils ein Schaltbild eines weiteren Ausführungsbeispiels der erfindungsgemäßen Überwachungsschaltung;
- Fig. 4: ein Schaltbild einer Signalauswertungseinrichtung eines weiteren Ausführungsbeispiels der erfindungsgemäßen Überwachungsschaltung.

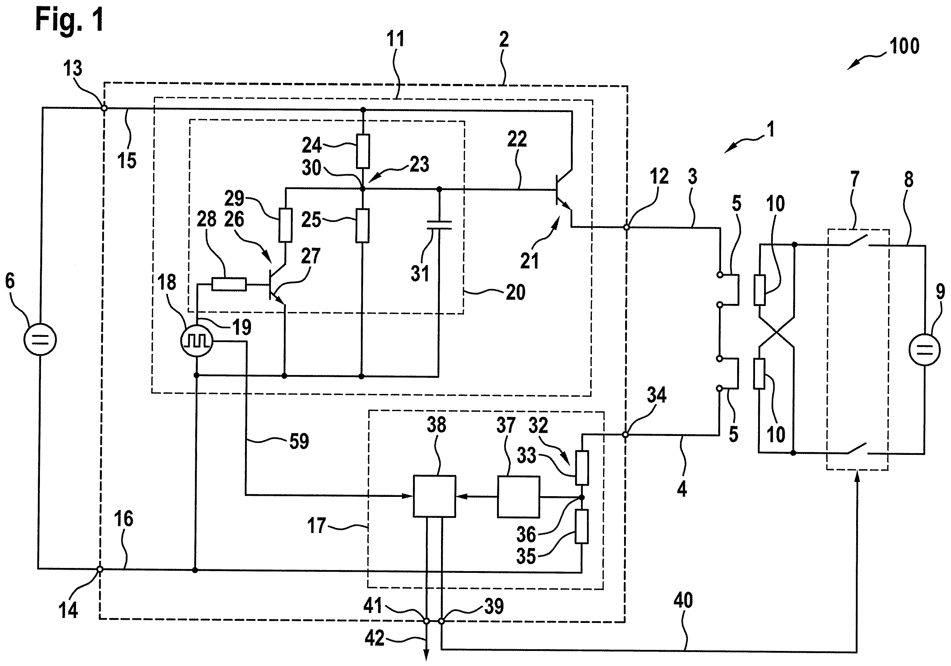

Fig. 1 ist ein Schaltbild eines Ausführungsbeispiels einer Anordnung 100 mit einem Interlocksystem 1, das ein Ausführungsbeispiel einer Überwachungsschaltung 2 umfasst, und mit zwei Funktionseinheiten 10.

Das Interlocksystem 1 umfasst eine erste Überwachungsleitung 3, eine zweite Überwachungsleitung 4, zwei Leitungsbrücken 5, mittels welchen die Überwachungsleitungen 3, 4 in einem geschlossenen Zustand des Interlocksystems 1 elektrisch leitend verbunden sind, und eine Gleichspannungsquelle 6. Das Interlocksystem 1 wird im vorliegenden Ausführungsbeispiel in einem Hochspannungsbordnetz 8 eines Fahrzeugs eingesetzt. Die Anordnung 100 umfasst ferner eine Hochvoltbatterie 9 des Hochspannungsbordnetzes 8 und eine Trenneinreichung 7, mittels welcher die Hochvoltbatterie 9 von den Funktionseinheiten 10 trennbar ist.

Den Funktionseinheiten 10 ist jeweils eine der Leitungsbrücken 5 zugeordnet. Alternativ sind die Leitungsbrücken 5 einer einzigen Funktionseinheit 10 zugeordnet. Exemplarisch sind eine Leitungsbrücke 5 einem Stecker der Funktionseinheit 10 und eine Leitungsbrücke 5 einer Abdeckung eines Gerätegehäuses der Funktionseinheit 10 zugeordnet. Ein Beispiel für eine Funktionseinheit 10 ist ein Wechselrichter zum Wandeln einer von der Hochvoltbatterie 9 bereitgestellten Spannung in eine Wechselspannung für eine elektrische Maschine (nicht gezeigt) zum Antreiben eines Fahrzeugs (nicht gezeigt). Die Zuordnung kann dadurch realisiert sein, dass die Leitungsbrücke 5 die Überwachungsleitungen 3, 4 beim Öffnen der Abdeckung bzw. beim Lösen des Steckers trennt. Da die Trenneinrichtung 7 und die Hochvoltbatterie 9 in einem vom Gerätegehäuse getrennten gemeinsamen Batteriegehäuse angeordnet sind, kann das Interlocksystem 1 als lokales Interlocksystem bezüglich der Funktionseinheiten 10 bzw. der Funktionseinheit 10 aufgefasst werden.

Die Überwachungsschaltung 2 umfasst eine Signalerzeugungseinrichtung 11, welche zum Erzeugen eines zwischen einer ersten Überwachungsspannung und einer zweiten Überwachungsspannung wechselnden Überwachungssignals für die erste Überwachungsleitung 3 eingerichtet ist. Dazu ist die erste Überwachungsleitung 3 unmittelbar mit einem Ausgang 12 der Überwachungsschaltung 2 verbunden. Die Signalerzeugungseinrichtung 11 ist dazu eingerichtet, das Überwachungssignal aus einer von der Gleichspannungsquelle 6 an Versorgungsanschlüssen 13, 14 der Überwachungsschaltung 2 bereitgestellten Versorgungsspannung zu erzeugen. Die Versorgungsspannung weist ein erstes Versorgungpotential 15 und ein niedrigeres zweites Versorgungspotential 16, welches ein Massepotential des Fahrzeugs und/oder ein Gehäusepotential des Gehäuses ist und insoweit als Bezugspotential gewählt ist, auf. Die Erzeugung des Überwachungssignals erfolgt derart, dass die Überwachungsspannungen zwischen den Versorgungspotentialen 15, 16 liegen, wobei die erste Überwachungsspannung oberhalb der zweiten Überwachungsspannung liegt.

Die Überwachungsschaltung 2 umfasst ferner eine Signalauswertungseinrichtung 17, mittels welcher ein auf das Bezugspotential bezogener Spannungsverlauf auf der zweiten Überwachungsleitung 4 erfassbar ist und die zum Ermitteln einer Unterbrechung der Überwachungsleitungen 3, 4, einer durch eine auf die Versorgungsspannung bezogene Störspannung verursachten Störung auf einer der Überwachungsleitungen 3, 4 und einer Störung der Überwachungsschaltung 2 anhand des Spannungsverlaufs eingerichtet ist, was später genauer erläutert wird.

Im Detail umfasst die Signalerzeugungseinrichtung 11 eine Generatoreinheit 18, welche zum Ausgeben eines die Wechsel zwischen den Überwachungsspannungen beschreibenden Generatorsignals 19 eingerichtet ist, und eine Spannungswandlungseinheit 20, welche zum Wandeln der Überwachungsspannungen in Abhängigkeit des Generatorsignals 19 eingerichtet ist. Daneben umfasst die Signalerzeugungseinrichtung 11 einen Impedanzwandler 21, welcher zum Erzeugen des Überwachungssignals in Abhängigkeit eines Ausgangssignals 22 der Spannungswandlungseinheit 20 eingerichtet ist.

Das Generatorsignal 19 beschreibt einen getakteten Wechsel zwischen den Überwachungsspannungen, der vorliegend ein Tastverhältnis von beispielsweise 50% aufweist. Die Spannungswandlungseinheit 20 umfasst einen zwischen die Versorgungspotentiale 15, 16 geschalteten Spannungsteiler 23 mit einem ersten Widerstandselement 24 am ersten Versorgungspotential 15 und einem zweiten Widerstandselement 25 am zweiten Versorgungspotential 16. Daneben umfasst die Spannungswandlungseinheit 20 ein durch das Generatorsignal 19 ansteuerbares Schaltelement 26, welches vorliegend durch einen Transistor 27 mit einem Vorwiderstand 28 an dessen Steueranschluss realisiert ist. In Reihe mit dem Schaltelement 26 ist ein drittes Widerstandselement 29 geschaltet, wobei das Schaltelement 26 und das dritte Widerstandselement 29 parallel zum zweiten Widerstandselement 25 geschaltet sind. Dadurch ist der Widerstandswert des das zweite Widerstandselement 25 und das dritte Widerstandselement 29 aufweisenden Zweigs des Spannungsteilers 23 in Abhängigkeit des Generatorsignals 19 veränderlich. Steuert mithin die Generatoreinheit 18 das Schaltelement 26 zum Sperren an, liegt an einem Abgriff 30 des Spannungsteilers 23 ein Ausgangssignal 22 an, welches ein Bereitstellen der ersten Überwachungsspannung am Ausgang 12 bewirkt. Steuert das Generatorsignal 19 das Schaltelement 26 zum Leiten an, so ergibt sich auf Grund der Parallelschaltung des zweiten Widerstandselements 25 mit dem dritten Widerstandselement 29 am Abgriff 30 ein Ausgangssignal 22, welches ein Bereitstellen der zweiten Überwachungsspannung am Ausgang 12 bewirkt. Außerdem weist die Spannungswandlungseinheit 20 einen Kondensator 31 auf, der zwischen den Abgriff 30 und das zweite Versorgungspotential 16 geschaltet ist, um Überschwingungen beim Wechsel zwischen den Überwachungsspannungen zu dämpfen und eine Flankensteilheit beim Wechseln zwischen den Überwachungsspannungen einzustellen.

Das Ausgangssignal 22 der Spannungswandlungseinheit 20 wird dem Impedanzwandler 21 zugeführt. Dieser stellt die erste Überwachungsspannung und die zweite Überwachungsspannung am Ausgang 12 bereit.

Die Signalauswertungseinrichtung 17 umfasst einen Spannungsteiler 32, dessen erstes Widerstandselement 33 mit einem Eingang 34 der Überwachungsschaltung 2, an dem die zweite Überwachungsleitung 4 angeschlossen ist, verbunden ist. Ein zweites Widerstandselement 35 des Spannungsteilers 32 ist mit dem zweiten Versorgungspotential 16 verbunden. An einem Abgriff 36 des Spannungsteilers 32 ist somit ein Spannungsverlaufssignal, das den Spannungsverlauf in skalierter Form beschreibt, abgreifbar. Da der Impedanzwandler 21 einen ausreichend hohen Strom durch die Überwachungsleitungen 3, 4 treiben kann, ist der Spannungsteiler 32 der Signalauswertungseinrichtung 17 verhältnismäßig niederohmig im Vergleich zum Spannungsteiler 23 der Signalwandlungseinheit 20 gewählt. Mithin ermöglicht der Impedanzwandler 21, dass die Spannungsteiler 23, 32 nicht aufeinander abgestimmt werden müssen, da er eine Beeinflussung der Signalerzeugungseinrichtung 11 durch die Signalauswertungseinrichtung 17 weitgehend ausschließt.

Die Signalauswertungseinrichtung 17 umfasst ferner einen Analog-Digital-Wandler 37, welcher den durch den Spannungsteiler 32 skalierten Spannungsverlauf in Binärdaten wandelt. Diese Binärdaten sind einer Auswerteeinheit 38 der Signalauswertungseinrichtung 17 bereitstellbar, welche die Störungen auf den Überwachungsleitungen 3, 4 und die Störungen der Überwachungsschaltung 2 durch Auswerten des durch die Binärdaten beschriebenen Spannungsverlaufs erkennt und an einem Ausgang 39 der Überwachungsschaltung 2 ein Auslösesignal 40 sowie an einem Ausgang 41 der Überwachungsschaltung 2 eine Störungsinformation 42 bereitstellt.

Das Interlocksystem 1 ermöglicht eine Erkennung einer Trennung der Überwachungsleitungen 3, 4 infolge eines Entfernens einer der Leitungsbrücken 5. In diesem Fall gelangt das Überwachungssignal nicht mehr zum Eingang 34 der Überwachungsschaltung 2, so dass der Spannungsverlauf auf dem zweiten Versorgungspotential 16 liegt, woraufhin die Auswerteeinheit 38 das Auslösesignal 40 ausgibt. Durch das Auslösesignal 40 wird die Trenneinrichtung 7 zum Trennen der Hochvoltbatterie 9 von den Funktionseinheiten 10 angesteuert, da infolge der Unterbrechung der Überwachungsleitungen 3, 4 damit gerechnet wird, dass ein spannungsführendes Teil an den Funktionseinheiten 10 frei liegt und eine Gefahr der Berührung durch eine Person besteht.

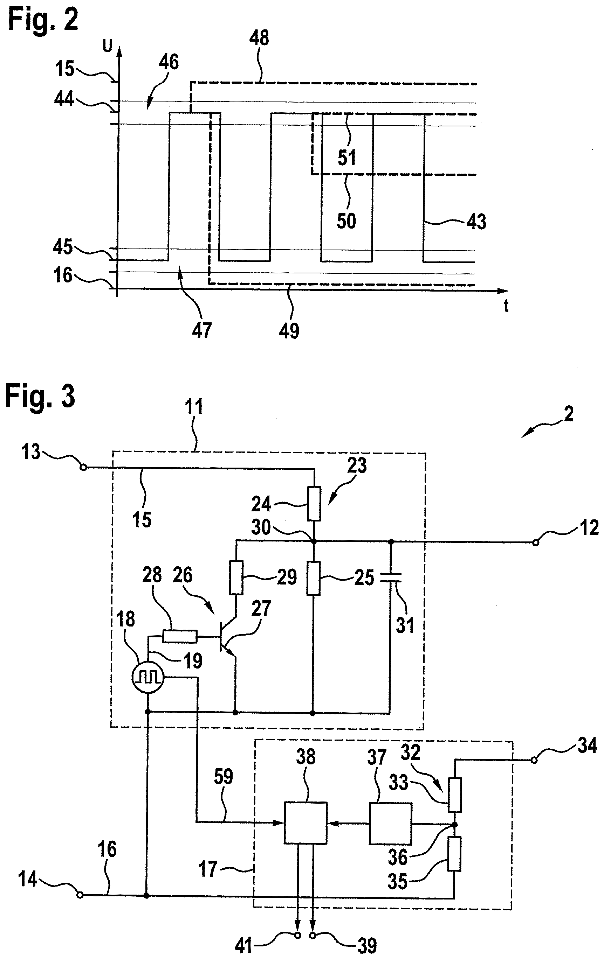

Anhand von Fig. 2, die Verläufe einer Spannung U über eine Zeit t zeigt, wird im Folgenden die Ermittlung von Störungen durch die Überwachungsschaltung 2 detailliert beschrieben.

Fig. 2 zeigt einen mit einer durchgezogenen Linie gekennzeichneten Spannungsverlauf 43 bezogen auf das zweite Versorgungspotential 16, wie er am Eingang 34 anliegt und von der Signalauswertungseinheit 17 erfasst wird. Der Spannungsverlauf 43 wechselt zwischen einer Spannung 44, die der ersten Überwachungsspannung entspricht, und einer Spannung 45, die der zweiten Überwachungsspannung entspricht.

Um die erste Überwachungsspannung sind ein erstes Toleranzintervall 46 und um die zweite Überwachungsspannung ein zweites Toleranzintervall 47 definiert. Die Toleranzintervalle 46, 47 sind überlappungsfrei und umfassen keine Störspannungen in Form der Versorgungspotentiale 15, 16 oder einer anderen harten Spannung, die in den Funktionseinheiten 10 verbreitet ist. In dem konkreten Beispiel gemäß Fig. 2 befinden sich die Überwachungsspannungen bzw. die Spannungen 44, 45 mittig in den Toleranzintervallen 46, 47.

Der Analog-Digital-Wandler 37 tastet den durch den Spannungsteiler 32 skalierten Spannungsverlauf 43 deutlich öfter, als es das Nyquist-Kriterium erfordert, ab. Die Auswerteeinheit 38 erkennt anhand von periodisch innerhalb der Toleranzintervalle 46, 47 liegenden Abtastwerten, dass die Überwachungsleitungen 3, 4 durch die Leitungsbrücken 5 verbunden sind, so dass die Ausgabe des Auslösesignals 40 unterbleibt. Da bei der praktischen Anwendung die in Fig. 2 schematisch dargestellten unendlichen Flankensteilheiten des Spannungsverlaufs 43 nicht realisierbar sind, wird ein störungsfreier Betrieb auch dann durch die Auswerteeinheit 38 ermittelt, wenn ein während des Wechsels der Überwachungsspannungen erfasster Abtastwert zwischen den Toleranzintervallen 46, 47 liegt und der Wechsel zwischen den Überwachungsspannungen kurz im Vergleich zum Abtastintervall ist.

Im Folgenden werden mögliche Störungen, die mittels der Überwachungsschaltung 2 erkennbar sind, anhand von gestrichelt dargestellten Spannungsverläufen 48 bis 51, die vom Spannungsverlauf 43 abweichende Spannungsverläufe beschreiben, erläutert:
Der Spannungsverlauf 48 unterscheidet sich vom Spannungsverlauf 43 dadurch, dass er ab einem gewissen Zeitpunkt zum ersten Versorgungspotential 15 hin außerhalb des ersten Toleranzintervalls 46 liegt. Dies weist typischerweise auf einen Kurzschluss einer der Überwachungsleitungen 3, 4 mit einem das erste Versorgungspotential 15 führenden Teil hin. Die Auswerteeinheit 38 ermittelt anhand der erstmaligen Erfassung eines oberhalb des ersten Toleranzintervalls 46 liegenden Abtastwerts, dass eine solche durch das erste Versorgungspotential als Störspannung verursachte Störung vorliegt und gibt das Auslösesignal 40 aus. Daneben gibt die Auswerteeinheit 38 eine Störungsinformation 42 aus, die beschreibt, dass ein Kurzschluss einer der Überwachungsleitungen 3, 4 mit dem ersten Versorgungspotential 15 vorliegt.

Der Spannungsverlauf 49 unterscheidet sich vom Spannungsverlauf 43 dadurch, dass er einem gewissen Zeitpunkt zum zweiten Versorgungspotential 16 hin außerhalb des zweiten Toleranzintervalls 47 liegt. Dies deutet darauf hin, dass ein Kurzschluss einer der Überwachungsleitungen 3, 4 mit dem zweiten Versorgungspotential 16 vorliegt oder dass eine der Leitungsbrücken 5 die Überwachungsleitungen 3, 4 nicht mehr miteinander verbindet. Ab der erstmaligen Erfassung eines derartigen Abtastwerts durch die Auswerteeinheit 38 gibt diese das Auslösesignal 40 und eine Störungsinformation 42 aus, die beschreibt, dass ein Kurzschluss einer der Überwachungsleitungen 3, 4 mit dem zweiten Versorgungspotential 16 oder eine Entfernung der Leitungsbrücken 5 vorliegt.

Der Spannungsverlauf 50 unterscheidet sich vom Spannungsverlauf 43 dadurch, dass er ab einem gewissen Zeitpunkt zwischen den Toleranzintervallen 46, 47 liegt. Dies deutet auf einen Kurzschluss einer der Überwachungsleitungen 3, 4 mit einer zwischen den Versorgungspotentialen 15, 16 liegenden Störspannung hin. Da ein einzelner, zwischen den Toleranzintervallen 46, 47 liegender Abtastwert jedoch nur auf einer Abtastung während des Wechsels der Überwachungsspannungen hindeutet, gibt die Auswerteeinheit 38 erst ab der Erfassung zweier aufeinanderfolgender, zwischen den Toleranzintervallen 46, 47 liegender Abtastwerte das Auslösesignal 40 aus. Gleichzeitig gibt sie eine Störungsinformation 42 aus, die beschreibt, dass ein Kurzschluss einer der Überwachungsleitungen 3, 4 mit einer zwischen den Versorgungspotentialen 15, 16 liegenden Störspannung vorliegt. Diese Störspannung ist beispielsweise die beim Betrieb der Funktionseinheit 10 innerhalb des Gehäuses erzeugte bzw. vorliegende Spannung.

Der Spannungsverlauf 51 unterscheidet sich vom Spannungsverlauf 43 dadurch, dass er ab einem gewissen Zeitpunkt keinen Wechsel zwischen dem Toleranzintervallen 46, 47 vollzieht, mithin in einem der Toleranzintervalle 46, 47, vorliegend dem ersten Toleranzintervall 46, verharrt. Dies deutet auf eine Störung der Signalerzeugungseinrichtung 11 und/oder der Signalauswertungseinrichtung 17, insbesondere ihres Analog-Digital-Wandlers 37, hin. Ein solche Störung ist beispielsweise ein sogenannter "stuck at"-Fehler. Erkennt die Auswerteeinheit 38 anhand mehrerer aufeinanderfolgend erfasster Abtastwerte, die für eine vorgegebene Dauer oder länger innerhalb eines der Toleranzintervalle 46, 47 liegen, eine Störung der Überwachungsschaltung 2, so gibt sie das Auslösesignal 40 und eine eine Störung der Überwachungsschaltung 2 beschreibende Störinformation 42 aus.

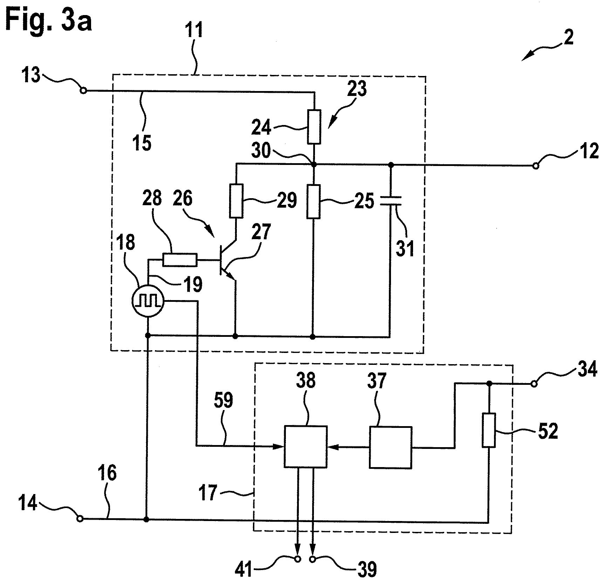

Fig. 3 ist ein Schaltbild eines weiteren Ausführungsbeispiels einer Überwachungsschaltung 2, die der in Fig. 1 gezeigten bis auf die nachfolgend beschriebenen Abweichungen entspricht. Dabei sind gleiche oder gleichwirkende Komponenten mit identischen Bezugszeichen versehen.

Die Signalerzeugungseinrichtung 11 weist keinen Impedanzwandler auf. Stattdessen ist der Abgriff 30 des Spannungsteilers 23 direkt mit dem Ausgang 12 verbunden. Der Spannungsteiler 23 ist dabei im Vergleich zum Spannungsteiler 32 der Signalauswertungseinrichtung 17 niederohmig, sodass er einen Strom entlang den Überwachungsleitungen 3, 4 selbst treiben kann. Insoweit wird bei dem Ausführungsbeispiel gemäß Fig. 3 auf den Impedanzwandler 21 (siehe Fig. 1) verzichtet. Der Spannungsteiler 32 passt den Spannungsbereich des Signals am Eingang 34 an den Eingangsspannungsbereich des Analog-Digital-Wandlers 37 an. Zusätzlich sorgt der Spannungsteiler 32 dafür, dass bei einer Trennung der Überwachungsleitungen 3, 4 die gemessene Spannung angemessen schnell absinkt.

Fig. 3a zeigt ein weiteres Ausführungsbeispiel der in Fig. 3 gezeigten Schaltung. Hier liegt der Spannungsbereich des Signals am Eingang 34 bereits im Eingangsspannungsbereich des Analog-Digital-Wandlers 37. Anstatt des Spannungsteilers 32 ist hier ein Widerstandselement 52 ausreichend, das ein definiertes und schnelles Abfallen der Spannung am Eingang 34 bei einer Trennung der Überwachungsleitungen 3, 4 ermöglicht.

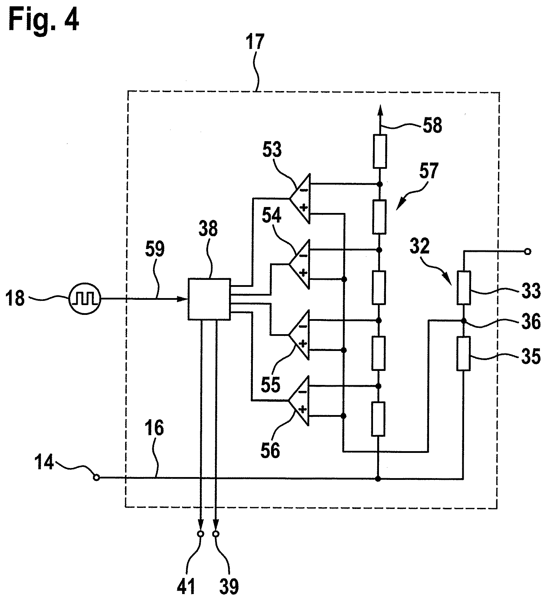

Fig. 4 zeigt eine Signalauswertungseinrichtung 17 gemäß einem weiteren Ausführungsbeispiel einer Überwachungsschaltung, die einem der zuvor beschriebenen Ausführungsbeispiele bis auf die nachfolgend beschriebenen Abweichungen entspricht. Dabei sind gleiche oder gleichwirkende Komponenten mit identischen Bezugszeichen versehen.

Die Signalauswertungseinrichtung 17 weist vier Komparatoren 53 bis 56 auf, deren Ausgänge mit der Auswerteeinheit 38 verbunden sind. Die positiven Eingänge der Komparatoren 53 bis 56 sind mit dem Abgriff 36 des Spannungsteilers 32 verbunden. Daneben umfasst die Signalauswertungseinrichtung 17 eine Reihenschaltung 57 mehrerer Widerstandselemente zwischen einem weiteren Potential 58 und dem zweiten Versorgungspotential 16. Abgriffe zwischen einem jeweiligen Paar benachbarter Widerstandselemente der Reihenschaltung 57 sind mit den negativen Eingängen der Komparatoren 53 bis 56 verbunden und stellen Referenzspannungen bereit, die den Grenzen der in Fig. 2 gezeigten Toleranzintervalle 46, 47 entsprechen. Die Auswerteeinheit 38 kann dementsprechend analog zu der bezüglich Fig. 2 ausgeführten Auswertung anhand der Ausgangssignale der Komparatoren 53 bis 56 die zuvor beschriebenen Störungen ermitteln.

Gemäß einem weiteren Ausführungsbeispiel, welches dem in Fig. 4 gezeigten Ausführungsbeispiel entspricht, kann die Signalauswertungseinrichtung 17 auch ein Widerstandselement 52 anstatt des Spannungsteilers 32 gemäß Fig. 3 bzw. 3a aufweisen.

Gemäß einem weiteren Ausführungsbeispiel, das einem der zuvor beschriebenen entspricht, ist eine einen Signalzustand des Überwachungssignals beschreibende Signalinformation 59 (siehe Fig. 1, 3 und 4) von der Signalerzeugungseinrichtung 11 an die Signalauswertungseinrichtung 17 übermittelbar, was durch eine Verbindung zwischen der Generatoreinheit 18 und der Auswerteeinheit 38 dargestellt ist. Die Signalauswertungseinrichtung 17 ist ferner zum Erkennen der Störung anhand eines Vergleichs eines erfassten Werts des Spannungsverlaufs 48 bis 51 mit dem erhaltenen Signalzustand des Überwachungssignals eingerichtet. Durch die Signalinformation 59 sind der Auswerteeinheit 38 die Zeitpunkte, an denen ein Wechsel zwischen den Überwachungsspannungen erfolgt, bekannt, so dass auch unregelmäßige Wechsel zwischen den Überwachungsspannungen vorgesehen sein können und/oder bei den Spannungsverläufen 50, 51, unter Berücksichtigung hinreichend kleiner Signallaufzeiten der Signalinformation 59, bereits mit einem Abtastwert die entsprechende Störung ermittelt werden kann.

Bei den Ausführungsbeispielen gemäß den Fig. 1 und 3 sind die Generatoreinheit 18, die Auswerteeinheit 38 und der Analog-Digital-Wandler 37 durch einen Mikrocontroller realisiert. Beim Ausführungsbeispiel gemäß Fig. 4 sind die Generatoreinheit 18 und die Auswerteeinheit 38 durch einen Mikrocontroller realisiert.

Das in Fig. 1 gezeigte Interlocksystem 1 weist eine durch die Leitungsbrücken 5 gebildete Stromschleife auf, deren Unterbrechung durch die Überwachungsschaltung 2 überwacht wird. Bei einem alternativen Ausführungsbeispiel des Interlocksystems 1 weist dieses separate Stromschleifen für eine jeweilige Leitungsbrücke 5 auf, die jeweils separat durch die Überwachungsschaltung 2 oder durch eine mehrere Signalauswertungseinrichtung 17 umfassende Überwachungsschaltung 2 überwacht werden.

Bei einem weiteren Ausführungsbeispiel, das im Übrigen den zuvor beschriebenen entspricht, handelt es sich nicht um ein lokales Interlocksystem, sondern um ein zentrales Interlocksystem. Dabei ist die Überwachungsschaltung 2 mit der Trenneinrichtung 7 im Batteriegehäuse angeordnet.

## Patentansprüche

1. Überwachungsschaltung (2) für ein Interlocksystem (1), das eine erste Überwachungsleitung (3), eine zweite Überwachungsleitung (4) und wenigstens eine Leitungsbrücke (5), mittels welcher die Überwachungsleitungen (3, 4) in einem geschlossenen Zustand des Interlocksystems (1) elektrisch leitend verbunden sind, aufweist, umfassend eine Signalerzeugungseinrichtung (11), welche zum Erzeugen eines zwischen einer ersten Überwachungsspannung und einer zweiten Überwachungsspannung wechselnden, auf ein Bezugspotential bezogenen Überwachungssignals für die erste Überwachungsleitung (3) eingerichtet ist, und eine Signalauswertungseinrichtung (17), mittels welcher ein auf das Bezugspotential bezogener Spannungsverlauf (43, 48-51) auf der zweiten Überwachungsleitung (4) erfassbar ist,
**dadurch gekennzeichnet, dass**
die Signalauswertungseinrichtung (17) zum Ermitteln einer durch eine auf das Bezugspotential bezogene Störspannung verursachten Störung auf einer der Überwachungsleitungen (3, 4) und/oder einer Störung der Überwachungsschaltung (2) mittels eines Vergleichs des Spannungsverlaufs (43, 48-51) mit einem vorgegeben ersten Toleranzintervall (46) um die erste Überwachungsspannung und mit einem vorgegebenen zweiten Toleranzintervall (47) um die zweite Überwachungsspannung eingerichtet ist.

2. Überwachungsschaltung nach Anspruch 1, wobei die Toleranzintervalle (46, 47) überlappungsfrei definiert sind und/oder zur Erkennung der Störspannung vorgesehene Spannungswerte nicht umfassen.

3. Überwachungsschaltung nach Anspruch 1 oder 2, wobei die Signalauswertungseinrichtung (17) zum Ermitteln der Störung auf den Überwachungsleitungen (3, 4) anhand eines nicht zwischen den Toleranzintervallen liegenden Wertes des erfassten Spannungsverlaufs (48, 49), der außerhalb der Toleranzintervalle (46, 47) liegt, eingerichtet ist.

4. Überwachungsschaltung nach einem der vorhergehenden Ansprüche, wobei die Signalauswertungseinrichtung (17) zum Ermitteln der Störung auf den Überwachungsleitungen (3, 4) anhand von wenigstens zwei aufeinanderfolgend erfassten, zwischen den Toleranzintervallen (46, 47) liegenden Werten des Spannungsverlaufs (50) eingerichtet ist.

5. Überwachungsschaltung nach einem der vorhergehenden Ansprüche, wobei die Signalauswertungseinrichtung (17) zum Ermitteln der Störung der Überwachungsschaltung (2) anhand von mehreren aufeinanderfolgend erfassten Werten des Spannungsverlaufs (51), die für oder länger als eine vorgegebene Dauer innerhalb eines Toleranzintervalls (46, 47) liegen, eingerichtet ist.

6. Überwachungsschaltung nach einem der vorhergehenden Ansprüche, wobei die Signalauswertungseinrichtung (17) zum Vergleichen des Spannungsverlaufs (43, 48-51) mehrere Komparatoren (53-56), deren Referenzwerte Grenzen der Toleranzintervalle (46, 47) entsprechen, oder einen Analog-Digital-Wandler (37) zum Wandeln des Spannungsverlaufs (43, 48-51) in Binärdaten umfasst.

7. Überwachungsschaltung nach einem der vorhergehenden Ansprüche, wobei eine einen Signalzustand des Überwachungssignals beschreibende Signalinformation (59) von der Signalerzeugungseinrichtung (11) an die Signalauswertungseinrichtung (17) übermittelbar ist und die Signalauswertungseinrichtung (17) zum Erkennen der Störung anhand eines Vergleichs eines erfassten Wertes des Spannungsverlaufs (43, 48-51) mit dem erhaltenen Signalzustand des Überwachungssignals eingerichtet ist.

8. Überwachungsschaltung nach einem der vorhergehenden Ansprüche, wobei die Signalerzeugungseinrichtung (11) dazu eingerichtet ist, das Überwachungssignal aus einer auf das Bezugspotential bezogenen Versorgungsspannung mit einem ersten Versorgungspotential (15) und einem zweiten Versorgungspotential (16) zu erzeugen.

9. Überwachungsschaltung nach Anspruch 8, wobei die Signalerzeugungseinrichtung (11) dazu eingerichtet ist, das Überwachungssignal derart aus der Versorgungsspannung zu erzeugen, dass die Überwachungsspannungen zwischen den Versorgungspotentialen (15, 16) liegen.

10. Überwachungsschaltung nach Anspruch 8 oder 9, wobei die Signalerzeugungseinrichtung (11) eine Generatoreinheit (18), welche zum Ausgeben eines die Wechsel zwischen den Überwachungsspannungen beschreibenden Generatorsignals (19) eingerichtet ist, und eine Spannungswandlungseinheit (20), welche zum Wandeln der Versorgungsspannung in Abhängigkeit des Generatorsignals (19) eingerichtet ist, umfasst.

11. Überwachungsschaltung nach Anspruch 10, wobei die Spannungswandlungseinheit (20) einen zwischen die Versorgungspotentiale (15, 16) geschalteten Spannungsteiler (23) und ein durch das Generatorsignal (19) ansteuerbares Schaltelement (26) umfasst, durch das ein Widerstandwert eines Zweigs des Spannungsteilers (23) veränderbar ist.

12. Überwachungsschaltung nach Anspruch 10 oder 11, wobei die Signalerzeugungseinrichtung (11) einen Impedanzwandler (21) umfasst, welcher zum Wandeln eines Ausgangssignals (22) der Spannungswandlungseinheit (20) in das Überwachungssignal eingerichtet ist.

13. Überwachungsschaltung nach einem der vorhergehenden Ansprüche, wobei die Signalauswertungseinrichtung (17) einen Spannungsteiler (32) umfasst, an dessen Abgriff (36) der Spannungsverlauf (43, 48-51) erfassbar ist.

14. Interlocksystem (1), umfassend eine erste Überwachungsleitung (3), eine zweite Überwachungsleitung (4) und wenigstens eine Leitungsbrücke (5), mittels welcher die Überwachungsleitungen (3, 4) in einem geschlossenen Zustand des Interlocksystems (1) elektrisch leitend verbunden sind, sowie eine Überwachungsschaltung (2) nach einem der vorhergehenden Ansprüche, wobei die Signalerzeugungseinrichtung (11) mit der ersten Überwachungsleitung (3) und die Signalauswertungseinrichtung (17) mit der zweiten Überwachungsleitung (4) verbunden sind.

15. Anordnung (100) mit einem Interlocksystem (1) nach Anspruch 14 und mit einer Funktionseinheit (10), welche mittels der Leitungsbrücke (5) überwachbar ist und dazu eingerichtet ist, während ihres Betriebs eine auf das Bezugspotential bezogene Spannung als Störspannung bereitzustellen, wobei die Spannung außerhalb der Toleranzintervalle (46, 47) liegt.

16. Verfahren zum Betreiben eines Interlocksystems (1), das eine erste Überwachungsleitung (3), eine zweite Überwachungsleitung (4) und wenigstens eine Leitungsbrücke (5), mittels welcher die Überwachungsleitungen (3, 4) in einem geschlossenen Zustand des Interlocksystems (1) elektrisch leitend verbunden sind, aufweist, umfassend folgende Schritte:
- Erzeugen eines zwischen einer ersten Überwachungsspannung und einer zweiten Überwachungsspannung wechselnden, auf ein Bezugspotential bezogenen Überwachungssignals für die erste Überwachungsleitung (3),
- Erfassen eines auf das Bezugspotential bezogenen Spannungsverlaufs (43, 48-51) auf der zweiten Überwachungsleitung (4),
- Ermitteln einer durch eine auf das Bezugspotential bezogene Störspannung verursachten Störung auf einer der Überwachungsleitungen (3, 4) und/oder einer Störung der Überwachungsschaltung (2) mittels eines Vergleichs des Spannungsverlaufs (43, 48-51) mit einem vorgegeben ersten Toleranzintervall (46) um die erste Überwachungsspannung und mit einem vorgegebenen zweiten Toleranzintervall (47) um die zweite Überwachungsspannung.

## Claims

1. A monitoring circuit (2) for an interlock system (1) having a first monitoring line (3), a second monitoring line (4) and at least one line bridge (5) by means of which the monitoring lines (3, 4) are electrically conductively connected in a closed state of the interlock system (1), comprising a signal generating device (11) which is configured to generate a monitoring signal for the first monitoring line (3) alternating between a first monitoring voltage and a second monitoring voltage and referenced to a reference potential, and a signal evaluation device (17) by means of which a voltage profile (43, 48-51) on the second monitoring line (4) referenced to the reference potential can be detected, **characterized in that** the signal evaluation device (17) is configured to determine a fault on one of the monitoring lines (3, 4) caused by an interference voltage referenced to the reference potential and/or a fault of the monitoring circuit (2) by means of a comparison of the voltage profile (43, 48-51) with a predetermined first tolerance interval (46) around the first monitoring voltage and with a predetermined second tolerance interval (47) around the second monitoring voltage.

2. The monitoring circuit according to claim 1, wherein the tolerance intervals (46, 47) are defined without overlap and/or do not comprise voltage values provided for detecting the interference voltage.

3. The monitoring circuit according to claim 1 or 2, wherein the signal evaluation device (17) is configured to determine the fault on the monitoring lines (3, 4) on the basis of a value of the detected voltage profile (48, 49) not lying between the tolerance intervals, which lies outside the tolerance intervals (46, 47).

4. The monitoring circuit according to any one of the preceding claims, wherein the signal evaluation device (17) is configured to determine the fault on the monitoring lines (3, 4) on the basis of at least two successively detected values of the voltage profile (50) lying between the tolerance intervals (46, 47).

5. The monitoring circuit according to any one of the preceding claims, wherein the signal evaluation device (17) is configured to determine the fault of the monitoring circuit (2) on the basis of a plurality of successively detected values of the voltage profile (51) lying within a tolerance interval (46, 47) for or longer than a predetermined duration.

6. The monitoring circuit according to any one of the preceding claims, wherein the signal evaluation device (17) comprises a plurality of comparators (53-56), the reference values of which correspond to limits of the tolerance intervals (46, 47), or an analog-to-digital converter (37) for converting the voltage profile (43, 48-51) into binary data, for comparing the voltage profile (43, 48-51).

7. The monitoring circuit according to any one of the preceding claims, wherein signal information (59) describing a signal state of the monitoring signal can be transmitted from the signal generating device (11) to the signal evaluation device (17), and the signal evaluation device (17) is configured to detect the fault on the basis of a comparison of a detected value of the voltage profile (43, 48-51) with the received signal state of the monitoring signal.

8. The monitoring circuit according to any one of the preceding claims, wherein the signal generating device (11) is configured to generate the monitoring signal from a supply voltage referenced to the reference potential having a first supply potential (15) and a second supply potential (16).

9. The monitoring circuit according to claim 8, wherein the signal generating device (11) is configured to generate the monitoring signal from the supply voltage such that the monitoring voltages lie between the supply potentials (15, 16).

10. The monitoring circuit according to claim 8 or 9, wherein the signal generating device (11) comprises a generator unit (18) which is configured to output a generator signal (19) describing the alternations between the monitoring voltages, and a voltage conversion unit (20) which is configured to convert the supply voltage depending on the generator signal (19).

11. The monitoring circuit according to claim 10, wherein the voltage conversion unit (20) comprises a voltage divider (23) connected between the supply potentials (15, 16) and a switching element (26) controllable by the generator signal (19), by means of which switching element a resistance value of a branch of the voltage divider (23) can be changed.

12. The monitoring circuit according to claim 10 or 11, wherein the signal generating device (11) comprises an impedance converter (21) which is configured to convert an output signal (22) of the voltage conversion unit (20) into the monitoring signal.

13. The monitoring circuit according to any one of the preceding claims, wherein the signal evaluation device (17) comprises a voltage divider (32), at the tap (36) of which the voltage profile (43, 48-51) can be detected.

14. An interlock system (1) comprising a first monitoring line (3), a second monitoring line (4) and at least one line bridge (5) by means of which the monitoring lines (3, 4) are electrically conductively connected in a closed state of the interlock system (1), as well as a monitoring circuit (2) according to any one of the preceding claims, wherein the signal generating device (11) is connected to the first monitoring line (3) and the signal evaluation device (17) is connected to the second monitoring line (4).

15. An arrangement (100) having an interlock system (1) according to claim 14 and having a functional unit (10) which can be monitored by means of the line bridge (5) and is configured to provide, during its operation, a voltage referenced to the reference potential as an interference voltage, wherein the voltage lies outside the tolerance intervals (46, 47).

16. A method for operating an interlock system (1) having a first monitoring line (3), a second monitoring line (4) and at least one line bridge (5) by means of which the monitoring lines (3, 4) are electrically conductively connected in a closed state of the interlock system (1), comprising the following steps:
• Generating a monitoring signal for the first monitoring line (3) alternating between a first monitoring voltage and a second monitoring voltage and referenced to a reference potential,
• Detecting a voltage profile (43, 48-51) on the second monitoring line (4) referenced to the reference potential,
• Determining a fault on one of the monitoring lines (3, 4) caused by an interference voltage referenced to the reference potential and/or a fault of the monitoring circuit (2) by means of a comparison of the voltage profile (43, 48-51) with a predetermined first tolerance interval (46) around the first monitoring voltage and with a predetermined second tolerance interval (47) around the second monitoring voltage.

## Revendications

1. Circuit de surveillance (2) pour un système de verrouillage (1), qui présente une première ligne de surveillance (3), une deuxième ligne de surveillance (4) et au moins un pont de ligne (5) au moyen duquel les lignes de surveillance (3, 4) sont reliées de manière électriquement conductrice dans un état fermé du système de verrouillage (1), comprenant un dispositif de génération de signaux (11), qui est conçu pour générer un signal de surveillance alternant entre une première tension de surveillance et une deuxième tension de surveillance et se référant à un potentiel de référence pour la première ligne de surveillance (3), et un dispositif d'évaluation de signaux (17), au moyen duquel une courbe de tension (43, 48-51) se référant au potentiel de référence peut être détectée sur la deuxième ligne de surveillance (4), **caractérisé en ce que** le dispositif d'évaluation de signaux (17) est conçu pour déterminer un défaut sur l'une des lignes de surveillance (3, 4) causé par une tension parasite se référant au potentiel de référence et/ou un défaut du circuit de surveillance (2) au moyen d'une comparaison de la courbe de tension (43, 48-51) avec un premier intervalle de tolérance prédéfini (46) autour de la première tension de surveillance et avec un deuxième intervalle de tolérance prédéfini (47) autour de la deuxième tension de surveillance.

2. Circuit de surveillance selon la revendication 1, dans lequel les intervalles de tolérance (46, 47) sont définis sans chevauchement et/ou ne comprennent pas des valeurs de tension prévues pour la détection de la tension parasite.

3. Circuit de surveillance selon la revendication 1 ou 2, dans lequel le dispositif d'évaluation de signaux (17) est conçu pour déterminer le défaut sur les lignes de surveillance (3, 4) sur la base d'une valeur de la courbe de tension détectée (48, 49) ne se situant pas entre les intervalles de tolérance, laquelle se situe en dehors des intervalles de tolérance (46, 47).

4. Circuit de surveillance selon l'une des revendications précédentes, dans lequel le dispositif d'évaluation de signaux (17) est conçu pour déterminer le défaut sur les lignes de surveillance (3, 4) sur la base d'au moins deux valeurs détectées successivement de la courbe de tension (50) se situant entre les intervalles de tolérance (46, 47).

5. Circuit de surveillance selon l'une des revendications précédentes, dans lequel le dispositif d'évaluation de signaux (17) est conçu pour déterminer le défaut du circuit de surveillance (2) sur la base d'une pluralité de valeurs détectées successivement de la courbe de tension (51), qui se situent pendant ou pendant plus d'une durée prédéfinie à l'intérieur d'un intervalle de tolérance (46, 47).

6. Circuit de surveillance selon l'une des revendications précédentes, dans lequel le dispositif d'évaluation de signaux (17) comprend, pour comparer la courbe de tension (43, 48-51), une pluralité de comparateurs (53-56) dont les valeurs de référence correspondent à des limites des intervalles de tolérance (46, 47), ou un convertisseur analogique-numérique (37) pour la conversion de la courbe de tension (43, 48-51) en données binaires.

7. Circuit de surveillance selon l'une des revendications précédentes, dans lequel une information de signal (59) décrivant un état de signal du signal de surveillance peut être transmise du dispositif de génération de signaux (11) au dispositif d'évaluation de signaux (17), et le dispositif d'évaluation de signaux (17) est conçu pour détecter le défaut sur la base d'une comparaison d'une valeur détectée de la courbe de tension (43, 48-51) avec l'état de signal reçu du signal de surveillance.

8. Circuit de surveillance selon l'une des revendications précédentes, dans lequel le dispositif de génération de signaux (11) est conçu pour générer le signal de surveillance à partir d'une tension d'alimentation se référant au potentiel de référence avec un premier potentiel d'alimentation (15) et un deuxième potentiel d'alimentation (16).

9. Circuit de surveillance selon la revendication 8, dans lequel le dispositif de génération de signaux (11) est conçu pour générer le signal de surveillance à partir de la tension d'alimentation de telle sorte que les tensions de surveillance se situent entre les potentiels d'alimentation (15, 16).

10. Circuit de surveillance selon la revendication 8 ou 9, dans lequel le dispositif de génération de signaux (11) comprend une unité de générateur (18), qui est conçue pour délivrer un signal de générateur (19) décrivant les alternances entre les tensions de surveillance, et une unité de conversion de tension (20), qui est conçue pour convertir la tension d'alimentation en fonction du signal de générateur (19).

11. Circuit de surveillance selon la revendication 10, dans lequel l'unité de conversion de tension (20) comprend un diviseur de tension (23) monté entre les potentiels d'alimentation (15, 16) et un élément de commutation (26) pouvant être commandé par le signal de générateur (19), au moyen duquel une valeur de résistance d'une branche du diviseur de tension (23) peut être modifiée.

12. Circuit de surveillance selon la revendication 10 ou 11, dans lequel le dispositif de génération de signaux (11) comprend un convertisseur d'impédance (21), qui est conçu pour convertir un signal de sortie (22) de l'unité de conversion de tension (20) en le signal de surveillance.

13. Circuit de surveillance selon l'une des revendications précédentes, dans lequel le dispositif d'évaluation de signaux (17) comprend un diviseur de tension (32), à la prise (36) duquel la courbe de tension (43, 48-51) peut être détectée.

14. Système de verrouillage (1), comprenant une première ligne de surveillance (3), une deuxième ligne de surveillance (4) et au moins un pont de ligne (5), au moyen duquel les lignes de surveillance (3, 4) sont reliées de manière électriquement conductrice dans un état fermé du système de verrouillage (1), ainsi qu'un circuit de surveillance (2) selon l'une des revendications précédentes, dans lequel le dispositif de génération de signaux (11) est relié à la première ligne de surveillance (3) et le dispositif d'évaluation de signaux (17) est relié à la deuxième ligne de surveillance (4).

15. Agencement (100) comprenant un système de verrouillage (1) selon la revendication 14 et comprenant une unité fonctionnelle (10), laquelle peut être surveillée au moyen du pont de ligne (5) et est conçue pour fournir, pendant son fonctionnement, une tension se référant au potentiel de référence en tant que tension parasite, dans lequel la tension se situe en dehors des intervalles de tolérance (46, 47).

16. Procédé pour faire fonctionner un système de verrouillage (1), qui présente une première ligne de surveillance (3), une deuxième ligne de surveillance (4) et au moins un pont de ligne (5), au moyen duquel les lignes de surveillance (3, 4) sont reliées de manière électriquement conductrice dans un état fermé du système de verrouillage (1), comprenant les étapes suivantes :
• génération d'un signal de surveillance pour la première ligne de surveillance (3), alternant entre une première tension de surveillance et une deuxième tension de surveillance et se référant à un potentiel de référence,
• détection d'une courbe de tension (43, 48-51) se référant au potentiel de référence sur la deuxième ligne de surveillance (4),
• détermination d'un défaut sur l'une des lignes de surveillance (3, 4) causé par une tension parasite se référant au potentiel de référence et/ou d'un défaut du circuit de surveillance (2) au moyen d'une comparaison de la courbe de tension (43, 48-51) avec un premier intervalle de tolérance prédéfini (46) autour de la première tension de surveillance et avec un deuxième intervalle de tolérance prédéfini (47) autour de la deuxième tension de surveillance.
